# EUROPEAN PATENT APPLICATION

(11) **EP 4 676 174 A1**
(43) Date of publication of application: **07.01.2026**
(21) Application number: 24186601.1
(22) Date of filing: 04.07.2024
(51) Int. Cl.: H05K 7/20

(54) **CONTROL CABINET AIR CONDITIONER WITH ENCLOSED PIPING BENDS**

(71) Applicant: Seifert Systems Ltd., 3000 Birzebbuga (MT)
(72) Inventor: Seifert, Michael Rudi, SWQ1015 Madliena (MT); Camilleri, Carl, Mosta MST3212 (MT); Zammit, Glenn, Ibragg SWQ2062 (MT)
(74) Representative: Meissner Bolte Partnerschaft mbB

(57) **Abstract**

The present inventions pertains to an air conditioner for a control cabinet, the air conditioner being mountable on the control cabinet to provide air-conditioning in an internal space of the control cabinet that is separated from an ambient space outside the control cabinet, the air conditioner comprising an evaporator with a heat exchanger that is configured to be in fluid communication with the internal space to cool the air in the internal space when the air conditioner is mounted on the control cabinet, the heat exchanger comprising a pipe system through which a refrigerant is guidable, the pipe system comprising at least two, in particular parallel, straight pipe portions, the straight pipe portions being connected to each other on at least one of their ends by at least one piping bend, wherein the straight pipe portions are arranged in the heat exchanger such that they are in fluid communication with the internal space when the air conditioner is mounted on the control cabinet, and wherein the at least one piping bend is enclosed in a safety space which is separated from the internal space of the control cabinet and from the external space when the air conditioner is mounted on the control cabinet.

## Description

The present invention relates to an air conditioner for a control cabinet according to the subject-matter of claim 1.

Air conditioners for control cabinets are used for stabilizing the temperature in an internal space of a control cabinet, which is configured to house electronic components such as switchgear. Air conditioners for control cabinets are often provided as dedicated units for installation on an existing control cabinet, or integrated with the control cabinet.

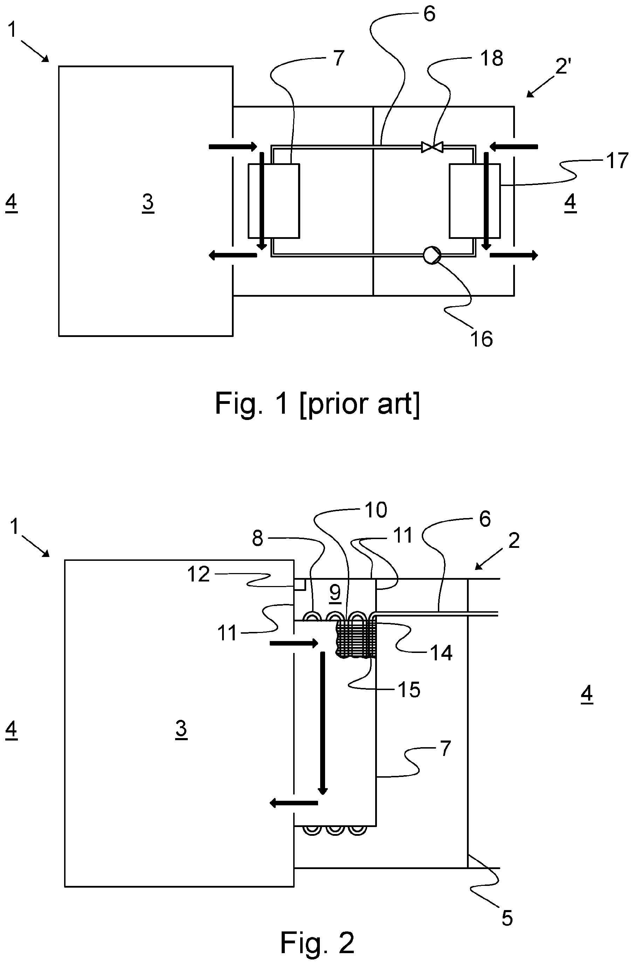

Fig. 1 shows a typical configuration of a control cabinet 1 with a conventional air conditioner 2' as known in the art. The control cabinet 1 is schematically shown as a rectangular unit delimiting an internal space 3 of the control cabinet 1. In the internal space 3, electronic components (not shown in Fig. 1) are housed. The air in the internal space 3 of the control cabinet 1 is cooled by the air conditioner 2'. For this, air from the internal space 3 (indicated by black arrows on the left side of Fig. 1) is passed through an evaporator 7 with piping through which a refrigerant flows. The air from the internal space 3 is cooled by the refrigerant. The refrigerant is circulated through the evaporator 7 through refrigerant circuit 6.

Downstream of the evaporator 7, the heated refrigerant, now in a gaseous state, is compressed in a compressor 16. Subsequently, the refrigerant is guided into a liquefier or condenser 17 comprising condenser tubes. Here, the refrigerant is subjected to heat exchange with the aid of supplied external air, i.e. ambient air 4 from the ambient space (indicated by black arrows on the right side of Fig. 1). The refrigerant releases heat to the cooler ambient air 4 during this process. In doing so, the temperature of the refrigerant drops and it begins to condense. The liquid refrigerant is then introduced into the evaporator 7 via the refrigerant circuit 6 through an expansion valve 18, which reduces its pressure and temperature and, thus, its cooling capacity.

A growing concern in the operation of air conditioners in general, and control cabinet air conditioners in particular, is the use of environmentally harmful refrigerants. For example, fluorinated refrigerants, despite their high suitability as refrigerants for efficiency and safety reasons, have a high global warming potential. Some are nearly inert to removal by chemical processes. If released, they can stay in the atmosphere for decades. For this reason, the use of such refrigerants is subject to regulations worldwide, including the F-gases Regulation No. 2024/573 of the European Union. In this context, the search for alternative refrigerants continues.

Many of the refrigerants complying with the various international regulations that are in use today and meet the requirements with regard to environmental compatibility have the disadvantage of being easily inflammable. The use of these refrigerants is particularly problematic in the context of control cabinet air conditioning. If a refrigerant of this type is admitted into the interior of a control cabinet, the energizing of a contactor or a relay in the cabinet interior may produce switching sparks that can lead to inflammation of the refrigerant.

In light of the above, it is an object of the present invention to provide an air conditioning solution for control cabinets that overcomes the mentioned problems. In particular, it is an object of the present invention to provide an air conditioner for control cabinets that is safe to use with flammable refrigerants.

The above object is solved by an air conditioner for a control cabinet according to the subject-matter of claim 1. Preferred embodiments of the present invention are defined by the subject-matter of the independent claims.

In particular, the object of the invention is solved by an air conditioner for a control cabinet, the air conditioner being mountable on the control cabinet to provide air-conditioning in an internal space of the control cabinet that is separated from an ambient space outside the control cabinet, the air conditioner comprising an evaporator with a heat exchanger that is configured to be in fluid communication with the internal space to cool the air in the internal space when the air conditioner is mounted on the control cabinet, the heat exchanger comprising a pipe system through which a refrigerant is guidable, the pipe system comprising at least two, in particular (essentially) parallel, straight pipe portions, the straight pipe portions being connected to each other on at least one of their ends by at least one piping bend, wherein the straight pipe portions are arranged in the heat exchanger such that they are in fluid communication with the internal space when the air conditioner is mounted on the control cabinet, and wherein the at least one piping bend is enclosed in a safety space which is separated from the internal space of the control cabinet and from the external space when the air conditioner is mounted on the control cabinet.

The invention is based on the insight that components with a risk of leakage should not be arranged in sections of the air conditioner that are in fluid communication with the internal space of the control cabinet when the air conditioner is mounted and in operation. For the cooling of the internal space, the heat exchanger of the evaporator has to be brought into fluid communication with the internal space. It has been recognized that the straight pipe portions of the evaporator, which are commonly formed integrally, do not represent a probable source of leakage. However, the piping bends required to connect the straight pipe portions of the evaporator are more prone to leakage, due to possible material fatigue induced by the bending of the piping pieces, and due to insufficient soldering or brazing at the connections between the piping bends and the straight pipe portions.

The invention reduces the risk induced by these potential leakage sources in a plurality of ways. On the one hand, enclosing the piping bends in a safety space separates the piping bends from the internal space of the control cabinet. Therefore, refrigerant that may escape from the refrigerant circuit of the air conditioner cannot enter the internal space of the control cabinet. By enclosing the most probable leakage sources in a safety space, leaking refrigerant is confined to the safety space. This also increases the safety of the air conditioner with respect to possible ignition sources in the vicinity of the control cabinet.

The present invention thus reduces the risk of ignition of leaking refrigerant in a constructively simple and (cost-)effective manner by enclosing the most probable source of leakage in a confined space where leaking refrigerant can be contained. Preferably, the safety space does not contain any ignition sources.

The air conditioner according to the present invention may be a configured as mountable air conditioner that is connectable to an existing control cabinet, or may be fixedly installed on the control cabinet. In the context of the present invention, it is merely decisive that the piping bends of the evaporator are fluidically separated from the internal space of the control cabinet, so that (essentially) no gas exchange between the internal space and the safety space is possible.

Preferably, the safety space is configured to confine refrigerant leaking from the at least one piping bend in case of a leakage at the at least one piping bend. This ensures that leaking refrigerant does not come into contact with any ignition sources inside the control cabinet or within its vicinity.

In order to fluidically separate the piping bends from the internal space (and, thus, from a space of the heat exchanger through which the straight pipe portions run), it is preferable to arrange a separation plate between the piping bends and the straight pipe portions. The term "straight pipe portion" designates a part, preferably the greatest part, of a straight pipe, preferably without the two ends of the straight pipe. The separation plate is configured such that the straight pipe penetrates the separation plate, with the straight pipe portion being arranged on one side of the separation plate and the end of the straight pipe being arranged on the other side. The position at which the straight pipe penetrates the separation plate is preferably sealed in a gas-tight manner, e.g. by providing a suitable gasket, or by brazing the straight pipe into the hole of the separation plate through which the straight pipe passes.

Further preferably, the heat exchanger comprises a fin pack through which the straight pipe portions pass, the fin pack being arranged in fluid communication with the internal space of the control cabinet. The provision of a fin pack improves the heat exchange between the air in the internal space of the control cabinet and the refrigerant flowing through the heat exchanger.

In a further preferred embodiment, the straight pipe portions are the only parts of the pipe system of the heat exchanger, further preferably the only parts of the refrigerant circuit of the air conditioner, which are in fluid communication with the internal space of the control cabinet. If the air conditioner is a mountable air conditioner, it is configured such that, in a mounted state, the straight pipe portions are the only parts of the pipe system of the air conditioner which are in fluid communication with the internal space of the control cabinet. As mentioned previously, the risk of refrigerant leakage from integrally formed straight pipe portions is virtually non-existent. Therefore, this configuration minimizes the risk of refrigerant leakage into the internal space of the control cabinet.

It is further preferable that the at least two straight pipe portions are connected with each other at respective ends by a plurality of piping bends, and wherein a plurality of safety spaces, preferably two safety spaces, is/are provided such that the piping bends are enclosed in the safety spaces. In order to improve the safety of the air conditioner, only one side of the evaporator on which piping bends are arranged may be provided with a safety space. This leaves the opposing side of the evaporator, on which further piping bends are arranged, as a potential source of leakage. In order to further minimize safety hazards imposed by leaking refrigerant, it is thus preferable to enclose the piping bends on both sides of the evaporator in a respective safety space. Herein, it is to be noted that, in principle, multiple safety spaces can be provided on the respective sides of the evaporator with the piping bends. For example, each piping bend could be confined in an individual safety space.

The constructively most straightforward solution is to confine all piping bends on one side of the evaporator in one common safety space. For this reason, it is preferred that the safety spaces at both ends of the straight pipe portions (or at two opposing sides of the evaporator) are common spaces confining or containing all piping bends, connecting portions or connector places, respectively, which are provided at the respective ends of the plurality of straight pipe portions.

Preferably, at both ends of the straight pipe portions separate safety spaces for each of the piping bends are provided. Separate safety spaces for each of the piping bends may designate one (separate) safety space for each piping bend, or one safety space on each side of the evaporator comprising the ends of the straight pipe portions, in which all piping bends of the respective side are confined.

In a particularly preferred embodiment, at least one refrigerant leakage sensor is provided in at least one safety space. This measure further increases the operational safety of the air conditioner. Since the most probable leakage sources of the evaporator are confined in a safety space, the concentration of leaking refrigerant will rise very quickly after occurrence of a leak. If the piping bends were just arranged outside the internal space of the control cabinet, but in full fluid communication with the ambient space of the control cabinet, leaking refrigerant would quickly dilute and be very difficult to detect. The combination of the safety space(s) for the piping bends with a refrigerant leakage sensor enables a very reliable detection of potential refrigerant leaks and enables the initiation of countermeasures at a very early moment after leakage has occurred.

The refrigerant leakage sensor may be a gas detector that is sensitive to a specific type of refrigerant used. Alternatively, a pressure sensor within the confined safety space may be employed as refrigerant leakage sensor.

In one embodiment, one refrigerant leakage sensor is used in the air conditioner. In a further preferred embodiment, each safety space is equipped with one refrigerant leakage sensor. This increases the reliability of leakage detection. In order to improve the sensitivity of leakage detection even further, one or more safety spaces may be provided with a plurality of refrigerant leakage sensors of the same or of different types. Leakage detection may be characterized by appropriate parameter thresholds, i.e., a leakage is detected if a parameter that is measurable with the refrigerant leakage sensor (e.g., a refrigerant concentration or a pressure in the safety space) exceeds a predetermined threshold value, or if the change in a measurable parameter exceeds a predetermined threshold.

In a preferred embodiment, the at least one refrigerant leakage sensor is communicatively coupled to a control unit of the air conditioner. The control unit of the air conditioner is configured to activate at least one countermeasure upon detection of leakage by the at least one refrigerant leakage sensor. Various countermeasures are conceivable. In the simplest configuration, the control unit is configured to turn off the compressor of the air conditioner upon detection of leakage. This stops the circulation of refrigerant and prevents further refrigerant from leaking. Additionally or alternatively, the control unit may be configured to close a valve in the refrigerant circuit, for example an expansion valve of the air conditioner, upon detection of leakage by the at least one refrigerant leakage sensor. Additionally or alternatively, the control unit may be configured to open the internal space of the control cabinet upon detection of leakage by the at least one refrigerant leakage sensor, in order to minimize the risk of a concentration increase of refrigerant in the internal space.

It is further preferred that the at least one safety space comprises opening means for enabling access to the respective safety space. Such opening means may be operable manually or automatically. The opening means may allow access to the safety space for inspection or maintenance of elements within the safety space, such as sensors or piping elements. An automatic operation of the opening means may be preferable if the control unit described above is used. In order to avoid a build-up of refrigerant concentration to hazardous levels in the safety space(s) upon occurrence of a leakage, the control unit may be configured to open the opening means upon detection of leakage by the at least one refrigerant leakage sensor.

According to a further (preferable) embodiment, the at least one safety space comprises a vent configured to establish a, preferably limited, fluid communication of (the) at least one safety space with the ambient space. Such a configuration may be, for example, preferable, if the air conditioner is configured to initiate only limited countermeasures in case of a leakage detection. For example, if the air conditioner (or a control unit of the air conditioner in communication with the at least one refrigerant leakage sensor) is only configured to shut down the compressor upon detection of leakage, vents may be provided to the at least one safety space in order to allow a reduction of overpressure in the safety spaces. It is preferred that the vents are configured such that only a limited fluid communication with the ambient space is enabled, in order to lower the risk of ignition of refrigerant flowing through the vent into the ambient space of the control cabinet.

In a further preferred embodiment, the evaporator is a microchannel evaporator, wherein, preferably, at least one header of the evaporator is enclosed in the safety space. Microchannel evaporators have an improved cooling efficiency, and the present invention is particularly suitable for use with microchannel evaporators. In a microchannel evaporator, the straight pipe portions are embodied as microchannel evaporator tubes, which are connected at their respective ends to a common microchannel evaporator header. In order to minimize the risk of refrigerant leakage in accordance with the present invention for this type of evaporator, at least one of the microchannel evaporator headers is confined in a safety space.

In the context of the present invention, a microchannel evaporator designates a heat exchanger comprising a plurality of, preferably parallel, tubes configured to pass refrigerant therethrough, wherein the tubes terminate in evaporator headers configured to distribute the refrigerant on the tubes. Particularly preferably, the tubes and/or headers are configured as having microchannels.

The above and further features and advantages of the present invention will become more readily apparent from the following detailed description of preferred embodiments of the invention with reference to the accompanying drawings, in which:
- Fig. 1: is a schematic drawing of a control cabinet with a conventional air conditioner according to the prior art;
- Fig. 2: is a schematic illustration of a control cabinet with an air conditioner according to a preferred embodiment of the present invention;
- Fig. 3: is a schematic illustration of a control cabinet with an air conditioner according to a further preferred embodiment of the present invention;
- Fig. 4: is a schematic illustration of a control cabinet with an air conditioner according to a further preferred embodiment of the present invention;
- Fig. 5: is a schematic illustration of a control cabinet with an air conditioner according to a further preferred embodiment of the present invention;
- Fig. 6: is a schematic illustration of a control cabinet with an air conditioner according to a further preferred embodiment of the present invention;
- Fig. 7: is a schematic illustration of a control cabinet with an air conditioner according to a further preferred embodiment of the present invention, using a microchannel evaporator;
- Fig. 8: is a schematic front view of the microchannel evaporator of Fig. 7.

Fig. 2 shows a schematic illustration of a control cabinet 1 with an air conditioner 2 according to a preferred embodiment of the invention. For the sake of simplicity, only a part of the air conditioner 2 decisive for explaining the concepts underlying the present invention is depicted.

The control cabinet 1 is schematically shown as a rectangle confining an internal space 3 of the control cabinet 1. Of course, the control cabinet 1 may be configured in a usual manner with means for mounting switchgear therein, and a door for enabling access to the internal space 3 of the control cabinet 1. In the context of the present invention, it is sufficient to characterize the control cabinet 1 by its property of enclosing the internal space 3 and separating it fluidically from ambient air 4.

The air conditioner 2 of Fig. 2 comprises an evaporator 7 that is configured to exchange heat with the air in the internal space 3 of the control cabinet 1. For this, air from the internal space 3 of the control cabinet 1 is guided through the evaporator 7 (indicated by black arrows in Fig. 2). The internal structure of the evaporator 7 is indicated in its top right corner. The evaporator 7 comprises a heat exchanger which comprises a plurality of (essentially parallel) straight pipe portions 14 which pass through a fin pack 15. The straight pipe portions 14 are mutually connected via piping bends 8 that are provided on opposite sides of the evaporator 7 at which the straight pipe portions 14 terminate. The fluid communication between the heat exchanger and the internal space 3 of the control cabinet 1 is ensured by suitable openings between the internal space 3 and the heat exchanger.

In order to separate the heat exchanger from components of the air conditioner 2 that require a fluid communication with the ambient air 4, such as a condenser, a separator 5 is provided. The separator 5 is configured such that the heat exchanger is enclosed to be in fluid communication with, preferably only in fluid communication with, the internal space 3 of the control cabinet 1.

Air from the internal space 3 of the control cabinet 1 streams along the lamellae of the fin pack 15 and the straight pipe portions 14 to exchange heat therewith. The straight pipe portions 14 are parts of a refrigerant circuit of the air conditioner 2 through which a refrigerant circulates. Fig. 2 schematically depicts one pipe of the refrigerant circuit 6 through which refrigerant is guided to or from the evaporator 7. A second pipe (not shown in Fig. 2) is provided for guiding refrigerant from or to the evaporator 7 for enabling a circulation of refrigerant through the circuit.

The evaporator 7, particularly the heat exchanger portion thereof, is in fluid communication with the internal space 3 of the control cabinet 1, in order to enable the heat exchange and, thus, conditioning, of the air inside the internal space 3. The principal components of the heat exchanger required for the air conditioning comprise only elements that have a low risk of leakage, namely the straight pipe portions 14 and the fin pack 15. A leakage risk mainly occurs at the piping bends 8 and their connection to the straight pipe portions 14. For this reason, the piping bends 8 are fluidically separated from the heat exchanger portion of the evaporator 7 by a separator plate 10 through which the piping penetrates.

In order to further minimize potential leakage hazards, the piping bends 8 on the upper side of the evaporator 7 in Fig. 2 are enclosed in a safety space 9. The safety space 9 is delimited from its environment by the separator plate 10 and a safety space enclosure 11, which is constituted by three plates in Fig. 2.

The safety space 9 delimits the piping bends 8 from the internal space 3 of the control cabinet 1. The safety space 9 also fluidically separates the piping bends 8 from the ambient space 4 surrounding the control cabinet 1, and confines refrigerant streaming out of a potential leak in the safety space 9. This minimizes the safety problems associated with a leakage of refrigerant from the evaporator 7. The only components of the air conditioner 2 which are in fluid communication with the internal space 3, and which are configured to enable a flow of refrigerant therethrough are the straight pipe portions 14. The probability of a leakage occurring in the straight pipe portions 14 is virtually negligible.

In the safety space 9, a refrigerant detection sensor 12 is provided. The refrigerant detection sensor 12 is configured to detect the presence of refrigerant in the safety space 9. For this, a gas sensor may be used which is configured to detect the presence of gas. Suitable sensors include, but are not limited to, electrochemical sensors, semiconductor sensors, catalytic sensors and optical, particularly IR sensors. Additionally or alternatively, a pressure sensor may be used which is able to monitor the presence of refrigerant in the safety space 9 through detection of a pressure increase in the safety space 9.

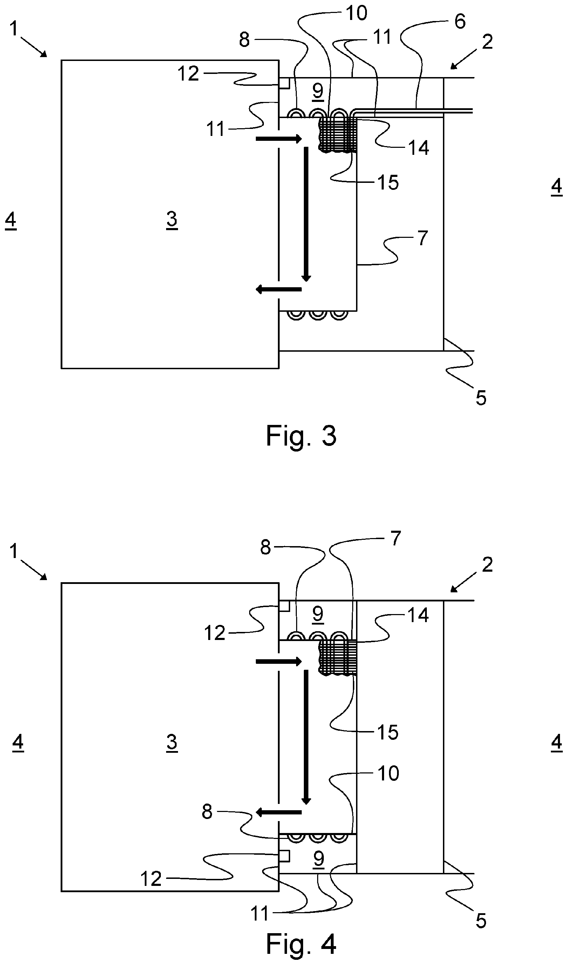

Fig. 3 shows a modification of the embodiment of Fig. 2. In the embodiment of Fig. 3, the part of the refrigerant circuit 6 to which the piping of the evaporator 7 is connected passes directly from the safety space 9 into an ambient side of the air conditioner 2. That is, in the embodiment according to Fig. 3, no part of the refrigerant circuit 6 is contained in the internal space 3. The only elements in the internal space 3 through which refrigerant can be guided are the straight pipe portions 14. This further improves the safety of the air conditioner 2 in operation.

Fig. 4 shows a modification of the embodiment of Fig. 2. The refrigerant circuit pipe 6 has been omitted for the sake of clarity, but it is evident that the air conditioner 2 of Fig. 4-7 also comprises a refrigerant circuit 6 to which the piping of the evaporator 7 is connected. The air conditioner 2 of Fig. 4 differs from that of Fig. 2 that both sides of the evaporator 7 comprising piping bends 8 is provided with a safety space 9 in which the piping bends 8 are encapsulated. This further improves the safety of the air conditioner 2. Refrigerant leakage sensors 12 are arranged in both safety spaces 9. Of course, the embodiment of Fig. 4 is also combinable with that of Fig. 3. In this case, the safety spaces 9 are configured such that no part of the refrigerant circuit 6 (not shown in Fig. 4 for the sake of clarity) passes through the internal space 3. It will be appreciated that, also in this embodiment, the only elements in the internal space 3 through which refrigerant can be guided are the straight pipe portions 14.

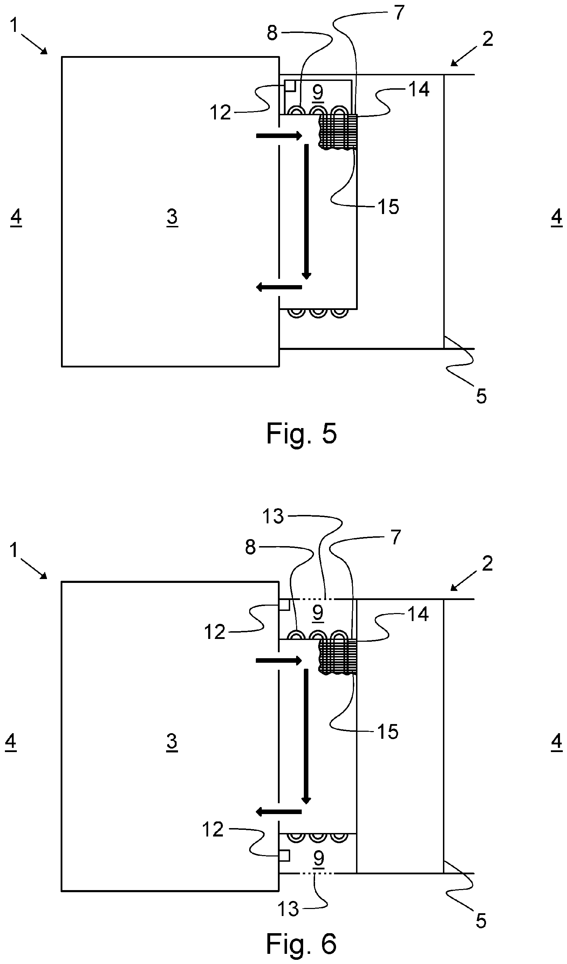

Fig. 5 shows a further modification of the embodiment of Fig. 2, in which the enclosure of the safety space 9 is separately formed from the enclosure of the evaporator 7. Obviously, the embodiment of Fig. 5 is readily modifiable in accordance with the principle of Fig. 4 by providing the enclosure of the safety space 9 in Fig. 4 also on the opposite side of the evaporator 7.

Fig. 6 shows a further embodiment of the air conditioner 2 according to the present invention. In this embodiment, the safety spaces 9 are equipped with vents 13. The vents 13 allow a limited fluid communication of the safety space 9 with the ambient space 4. However, the vents 13 are dimensioned such that a leakage of refrigerant into the safety space 9 still leads to a substantial concentration increase of refrigerant in the safety space 9 that is detectable with the refrigerant leakage sensors 9. Again, the embodiment of Fig. 6 can be combined with that of Fig. 3. In this case, the safety spaces 9 are configured such that no part of the refrigerant circuit 6 (not shown in Fig. 6 for the sake of clarity) passes through the internal space 3. It will be appreciated that, also in this embodiment, the only elements in the internal space 3 through which refrigerant can be guided are the straight pipe portions 14.

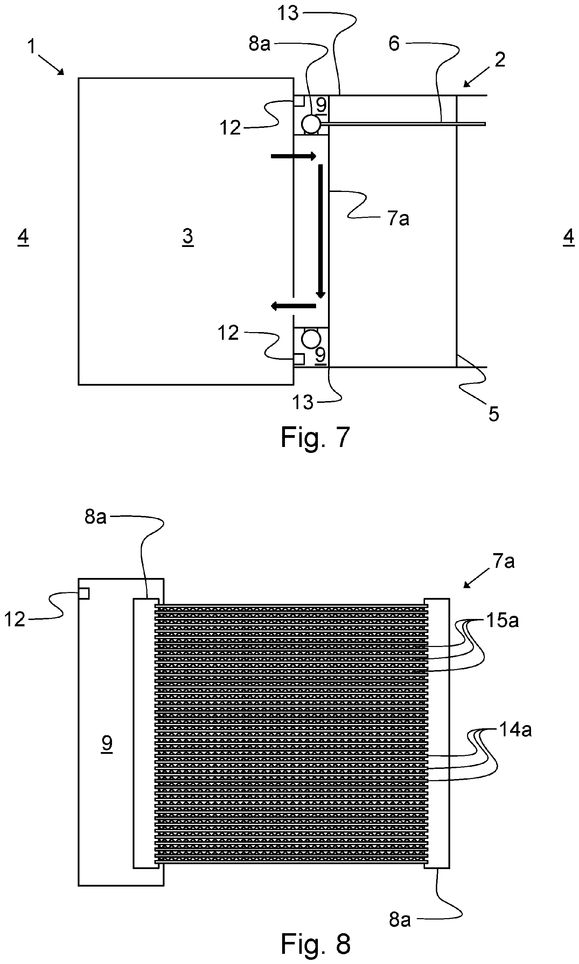

In order to improve the heat exchange efficiency of the heat exchanger, the evaporator 7 may be configured as a microchannel evaporator. A corresponding implementation is schematically depicted in Fig. 7, where a microchannel evaporator 7a is used for air conditioning of the internal space 3.

The configuration of the microchannel evaporator 7a is separately shown in Fig. 8. The microchannel evaporator 7a has a plurality of (substantially parallel) microchannel evaporator tubes 14a that replace the straight pipe portions 14 of the conventional evaporator 7 - i.e. the microchannel evaporator tubes 14a are configured to have refrigerant flow through them. Between the microchannel evaporator tubes 14a microchannel evaporator lamellae 15a are provided that serve to increase the surface for heat exchange with the air of the internal space 3.

The microchannel evaporator tubes 14a terminate in microchannel evaporator headers 8a located at the respective ends thereof. These headers 8a are more prone to leakage than the microchannel evaporator tubes 14a. For this reason, and in accordance with the invention at least one microchannel evaporator header 8a, preferably both microchannel evaporator headers 8a, are enclosed in the safety space 9, as shown in Fig. 7.

### List of reference signs:

- 1: cabinet
- 2: air conditioner
- 3: internal space
- 4: ambient air
- 5: separator
- 6: refrigerant circuit
- 7: evaporator
- 7a: microchannel evaporator
- 8: piping bends
- 8a: microchannel evaporator header
- 9: safety space
- 10: separator plate
- 11: safety space enclosure
- 12: refrigerant leakage sensor
- 13: vent
- 14: straight pipe portion
- 14a: microchannel evaporator tube
- 15: fin pack
- 15a: microchannel evaporator lamella
- 16: compressor
- 17: condenser
- 18: expansion valve

## Claims

1. Air conditioner (2) for a control cabinet (1), the air conditioner (2) being mountable on the control cabinet (1) to provide air-conditioning in an internal space (3) of the control cabinet (1) that is separated from an ambient space (4) outside the control cabinet (1),
the air conditioner (2) comprising an evaporator (7) with a heat exchanger that is configured to be in fluid communication with the internal space (3) to cool the air in the internal space (3) when the air conditioner (1) is mounted on the control cabinet (1),
the heat exchanger comprising a pipe system through which a refrigerant is guidable, the pipe system comprising at least two, in particular parallel, straight pipe portions (14),
the straight pipe portions (14) being connected to each other on at least one of their ends by at least one piping bend (8),
wherein the straight pipe portions (14) are arranged in the heat exchanger such that they are in fluid communication with the internal space (3) when the air conditioner (2) is mounted on the control cabinet (1), and wherein the at least one piping bend (8) is enclosed in a safety space (9) which is separated from the internal space (3) of the control cabinet (1) and from the external space (4) when the air conditioner (2) is mounted on the control cabinet (1).

2. Air conditioner (2) of claim 1, wherein the safety space (9) is configured to confine refrigerant leaking from the at least one piping bend (8) in case of a leakage at the at least one piping bend (8).

3. Air conditioner (2) of claim 1 or 2, wherein the heat exchanger comprises a fin pack (15) through which the straight pipe portions (14) pass, the fin pack (15) being arranged in fluid communication with the internal space (3) of the control cabinet (1).

4. Air conditioner (2) of any of the preceding claims, wherein the straight pipe portions (14) are the only parts of the pipe system which are in fluid communication with the internal space (3) of the control cabinet (1).

5. Air conditioner (2) of any of the preceding claims, wherein the at least two straight pipe portions (14) are connected with each other at respective ends by a plurality of piping bends (8), and wherein a plurality of safety spaces (9) is provided such that the piping bends (8) are enclosed in the safety spaces (9).

6. Air conditioner (2) of claim 5, wherein the safety spaces (9) at both ends of the straight pipe portions (14) are common spaces confining all piping bends (8), connecting portions or connector places, respectively, which are provided at the respective ends of the plurality of straight pipe portions (14).

7. Air conditioner (2) of claim 5, wherein at both ends of the straight pipe portions (14) separate safety spaces (9) for each of the piping bends (8) are provided.

8. Air conditioner (2) of any of the preceding claims, wherein at least one refrigerant leakage sensor (12) is provided in at least one safety space (9).

9. Air conditioner (2) of any of the preceding claims, wherein the at least one safety space (9) comprises opening means for enabling access to the respective safety space (9).

10. Air conditioner (2) of any of the preceding claims, wherein the at least one safety space (9) comprises a vent (13) configured to establish a, preferably limited, fluid communication of at least one safety space (9) with the ambient space (4).

11. Air conditioner (2) of any of the preceding claims, wherein the evaporator (7) is configured as a microchannel evaporator (7a), and wherein at least one header (8a) of the microchannel evaporator (7a) is confined in the safety space (9).
